Europäisches Patentamt

European Patent Office

Office européen des brevets

(19)

(11) Numéro de publication: **0 312 145 B1**

(12) **FASCICULE DE BREVET EUROPEEN**

(45) Date de publication de fascicule du brevet: **21.07.93** (51) Int. Cl.⁵: **H03H 11/12**, H03H 11/04

(21) Numéro de dépôt: **88202155.3**

(22) Date de dépôt: **30.09.88**

(54) **Circuit formant un filtre actif R.C. pour application coupe-bande ou passe-tout.**

(30) Priorité: **13.10.87 FR 8714111**

(43) Date de publication de la demande:
**19.04.89 Bulletin 89/16**

(45) Mention de la délivrance du brevet:
**21.07.93 Bulletin 93/29**

(84) Etats contractants désignés:
**DE FR GB IT**

(56) Documents cités:
**EP-A- 0 011 446**
**EP-A- 0 139 531**
**US-A- 4 001 712**

**IEEE SPECTRUM, décembre 1969, pages 64-68, New York, US; J. JOW: "A step-by-step active-filter design"**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT**

(72) Inventeur: **Deville, Yannick Societe Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris (FR)**

EP 0 312 145 B1

## Description

L'invention concerne un circuit formant un filtre RC actif pour application coupe-bande ou passe-tout dans les domaines des hautes et hyperfréquences, à fonction de transfert biquadratique, ayant une entrée E et une sortie S, ce circuit comportant une dite branche comprenant un bloc filtre-amplificateur F Pour réaliser une fonction filtre et amplificateur ayant pour entrée E et pour sortie $S_F$, et comportant un bloc $S_3$ sommateur pour réaliser la sommation $V_S$ entre le signal de sortie de ladite branche et le signal $V_E$ appliqué d l'entrée E du circuit.

L'invention trouve son application dans la réalisation de circuits intégrés formant filtres, dans le domaine des hautes fréquences et des hyperfréquences, pouvant par exemple, sous une forme de réalisation, être utilisés comme coupe-bande dans des doubleurs de fréquence pour rejeter le signal indésirable à la fréquence fondamentale ou bien pouvant, sous une autre forme de réalisation, être utilisés comme passe-tout en tant que déphaseurs ajustables à une fréquence donnée ou comme passe-tout en tant qu'éléments constitutifs de déphaseurs 90 degrés large-bande.

Un filtre actif passe-tout (A.P. = de l'anglosaxon ALL PASS) est déjà connu de l'état de la technique par la publication de J.TOW, dans "IEEE Spectrum, December 1969, pp.103-107", intitulée "A Step-by-Step Active-filter Design".

Cette publication décrit, entre autres, une réalisation de filtre passe-tout à fonction de transfert biquadratique, lequel filtre est représenté sur la figure 8 du document cité. Ce circuit comprend trois amplificateurs opérationnels montés en série, cette chaîne étant rétrobouclée. Un quatrième amplificateur opérationnel réalise la sommation de la sortie du premier amplificateur opérationnel et de l'entrée du circuit filtre.

Les amplificateurs opérationnels qui entrent dans la constitution de ce circuit présentent un gain qui est certes infini en basses fréquences, mais qui devient très faible en hautes et hyperfréquences. Pour cette raison, le circuit connu du document cité présente l'inconvénient de ne pouvoir être utilisé dans ces domaines de fréquence.

D'autre part, la chaîne rebouclée présente l'inconvénient d'entraîner, dans certaines conditions le circuit à osciller.

La figure 6 du document cité montre aussi un filtre actif passe-bande (PB = de l'anglo-saxon BAND-PASS) qui présente des caractéristiques similaires et donc exactement les mêmes inconvénients.

Les circuits connus du document cité présentent en outre les inconvénients suivants : d'une part, ils sont formés d'un grand nombre de transistors, ce qui :

- rend le coût de fabrication élevé dans tous les cas,
- entraîne l'occupation d'une grande surface et est désavantageux pour l'application aux circuits intégrés,
- entraîne une forte consommation et est également désavantageux pour l'application citée ci-dessus.

D'autre part, leur fréquence caractéristique n'est pas ajustable.

Enfin, les capacités utilisées dans ce circuit présentent une dimension importante et font que ce circuit n'est pas intégrable.

C'est pourquoi la présente invention propose un circuit de filtre actif qui permet de s'affranchir de ces inconvénients et qui notamment :

- peut fonctionner en hautes ou en hyperfréquences ;
- et, dans le cas de l'application aux hyperfréquences est facilement intégrable et présente une faible surface et une faible consommation ;
- présente des caractéristiques telles que la fréquence caractéristique est ajustable.

Selon l'invention, ce but est atteint au moyen d'un circuit tel que décrit dans le préambule caractérisé en ce que ladite branche comprend en outre un bloc amplificateur $A_2$ en série avec le bloc filtre-amplificateur F, placé entre la sortie $S_F$ de ce dernier et la sortie de ladite branche, en ce que le signal d'entrée $V_E$ est appliqué sur le bloc $S_3$ sommateur à travers un bloc amplificateur $A_1$, et en ce que le bloc $S_3$ sommateur est formé par le couplage des sorties des blocs amplificateurs $A_1$ et $A_2$ pour former la sortie S du circuit sur laquelle le signal de sortie $V_S$ est disponible.

L'invention sera mieux comprise au moyen de la description suivante illustrée par les figures ci-après annexées dont :

- la figure 1 qui représente le diagramme fonctionnel du circuit selon l'invention ;
- la figure 2a qui représente un exemple de réalisation du circuit selon l'invention au moyen de transistors à effet de champ ;
- la figure 2b qui représente le schéma équivalent de la partie passive PB du bloc F du circuit de la figure 2a ;

- les figures 2c et 2d qui représentent les courbes du rapport des tensions de sortie et d'entrée du circuit en fonction de la fréquence, respectivement en amplitude et en phase, ces courbes étant obtenues par simulation du circuit de la figure 2a.

Pour rendre plus clair l'exposé de l'invention on rappelle tout d'abord que la fonction de transfert d'un filtre actif coupe-bande (CB) du second ordre est donnée dans un tableau aux pages 94-95 de l'ouvrage intitulé "Filtres actifs" par Paul BILDSTEIN aux "Editions de la Radio" (9 rue Jacob, PARIS,-FRANCE).

Pour un filtre coupe-bande d'ordre 2 idéal, cette fonction de transfert s'écrit selon la relation (1) du tableau I ; relation dans laquelle :

s est la variable de Laplace qui se déduit de la variable p utilisée dans l'ouvrage cité (p étant la variable de Laplace réduite) par la relation (2) du tableau I, en posant d'autre part la relation (3) du tableau I.

Les autres paramètres de la fonction de la transfert (1) sont définis dans l'ouvrage de référence cité tels que :

$\omega_1$ = pulsation de réjection pour laquelle la relation (4) est vérifiée rigoureusement et donc pour laquelle la réjection est totale ;

$Q_0$ = facteur de qualité ou sélectivité qui indique la raideur des pentes de la courbe $|F(j\omega)|$ au voisinage de $\omega_1$ ;

$\omega_0$ = pulsation associée aux pôles de la fonction de transfert. Il a été choisi ici de faire correspondre l'écriture $\omega_0$ à l'écriture $\omega_p$ de l'ouvrage de référence cité ;

G = gain du circuit à basse fréquence (lorsque $\omega \to 0$ et que $s \to 0$, le terme facteur de G se réduit à 1, et $F(j\omega) \to G$).

La fonction de transfert d'un circuit non plus idéal, mais présentant une structure fixée réelle, pour laquelle ne sont pas posées de conditions sur la valeur des éléments, est, dans le cas le plus simple, du deuxième ordre et s'exprime par la relation (5).

On s'intéresse ici pour des raisons pratiques de simplicité au cas où $\omega_1 = \omega_0$ quelles que soient les valeurs des éléments du filtre, et où, $Q_1$ étant le facteur de réjection, il faut que la relation (6) soit vérifiée pour que le filtre fonctionne en coupe-bande, ce qui conduit à l'une des deux relations (7) ou (8).

Il apparaît alors un nouveau paramètre du filtre qui est la réjection R du filtre donnée par la relation (9) si on suppose que $\omega_1 \simeq \omega_0$.

Plus la valeur absolue de $Q_1$ (notée $|Q_1|$) est grande, meilleure est la réjection R. La réjection R est, à la limite, totale lorsque $|Q_1|$ est infinie.

On peut alors classer les coupe-bandes réels en deux catégories :

- la première catégorie correspond au cas où $Q_1$ est fini, et supérieur à 0 (relation (7)) quels que soient les éléments du filtre. Dans ces conditions, les filtres ne peuvent réaliser une réjection totale. C'est la valeur maximale de $Q_1$ qui fixe les limites du filtre. En effet, pour une valeur de $Q_1$ donnée, si la valeur de $Q_0$ augmente, la réjection R diminue.
- la seconde catégorie correspond au cas où le fait que $Q_1$ soit supérieur ou inférieur à 0 dépend au contraire des éléments du filtre. Dans ce cas, il existe des valeurs particulière des éléments telles que la relation (10) est vérifiée, et où la réjection R est totale. La fonction de tranfert G(s) donnée par la relation (5) se réduit alors à la fonction F(s) donnée par la relation (1).

Les filtres appartenant à la seconde catégorie présentent notamment la propriété de pouvoir être réalisés en choisissant des éléments tels que $Q_1 = -Q_0$ (et toujours $\omega_1 = \omega_0$), ce qui conduit à la relation (11).

Le filtre devient alors du type passe-tout d'ordre 2. La différence de phase entre les signaux de sortie et d'entrée passe de 0 à $-2\pi$ lorsque $\omega$ varie de 0 à l'infini.

Le but principal de l'invention est de réaliser des filtres actifs, comportant un nombre aussi restreint que possible d'éléments afin de favoriser l'intégration, et fonctionnant en hautes et hyperfréquences.

A cet effet, les circuits intégrés des filtres selon l'invention seront favorablement réalisés sur l'arséniure de gallium (GaAs).

En outre, selon l'invention, on a choisi de réaliser des filtres actifs coupe-bandes de la seconde catégorie, ce qui permet d'obtenir entre autres avantages :

- une réjection R importante et facilement réglable ;
- une sélectivité aussi grande que celle des filtres passifs connus de l'état de la technique cité plus loin.

Les filtres conformes à l'invention seront avantageusement utilisés dans des doubleurs de fréquences pour rejeter le signal indésirable à la fréquence fondamentale. Dans une version de filtres passe-tout conforme à l'invention, ils pourront être utilisés comme déphaseurs actifs ajustables à fréquence donnée, le retard de phase pouvant être réglé par une variation imposée à $\omega_1$.

EP 0 312 145 B1

Il est, d'autre part également connu de l'état de la technique des filtres coupe-bandes de la seconde catégorie fonctionnant en hautes fréquences. Mais ces circuits sont réalisés au moyen d'éléments passifs. On pourra considérer, par exemple, le circuit dit "Pont de Robinson" également connu sous le nom de "Pont de Wien", et représenté à la page 121 de l'ouvrage de référence intitulé "Electric Filters" par T.H. TURNEY (Ed. Pitman and Sons, London, England, 1945). Ce circuit, bien que capable de fonctionner en hyperfréquences, présente divers inconvénients et notamment :

- une sortie différentielle,
- une impédance de sortie élevée,
- un gain inférieur à l'unité à basses fréquences du fait qu'il est réalisé au moyen d'éléments passifs.

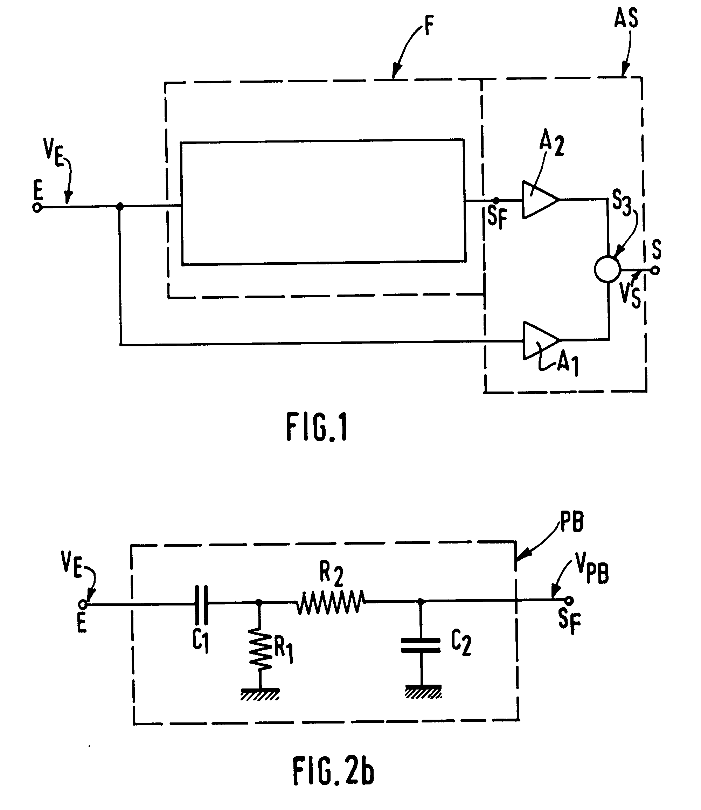

Le schéma fonctionnel du circuit coupe-bande selon l'invention est représenté à la figure 1. Ce circuit est formé de deux parties délimitées par des traits pointillés sur cette figure 1 :

- une première partie F à fonction de passe-bande (PB), et d'amplificateur ;
- une seconde partie AS à fonction d'amplificateur sommateur.

Le bloc F a pour fonction de transfert la relation (12).

En conséquence la fonction de transfert du circuit global est G(s) donné par la relation (5), en posant par rapport aux variables précédemment définies, les nouvelles variables conformément aux relations (13) et (14).

Le bloc AS est formé d'un amplificateur $A_1$ de gain $k_1$ et d'un amplificateur $A_2$ de gain ($k_2$). L'amplificateur $A_2$ est monté en cascade avec le bloc F, alors que l'amplificateur $A_1$ est en parallèle sur la branche formée de F et $A_2$. Le bloc $S_3$ fait la somme des sorties des amplificateurs $A_1$ et $A_2$, et fournit le signal de sortie $V_S$ du circuit selon l'invention, dont le signal d'entrée $V_E$ est appliqué au point commun d'entrée du bloc F et de l'amplificateur $A_1$.

Dans ces conditions on peut écrire la relation (15).

En identifiant les termes de la relation précédente et ceux de la relation (5) on obtient la relation (16) et $G = k_1$.

Le circuit selon l'invention constitue donc un filtre coupe-bande de la seconde catégorie définie plus haut, qui peut réaliser une réjection totale. Il peut également être fortement sélectif, car la sélectivité dépend essentiellement de la structure du bloc F et non pas du circuit global présenté figure 1.

Il peut également être utilisé comme passe-tout et plus généralement, on peut l'ajuster continûment de coupe-bande à passe-tout en ajustant $Q_1$.


Exemple de réalisation I

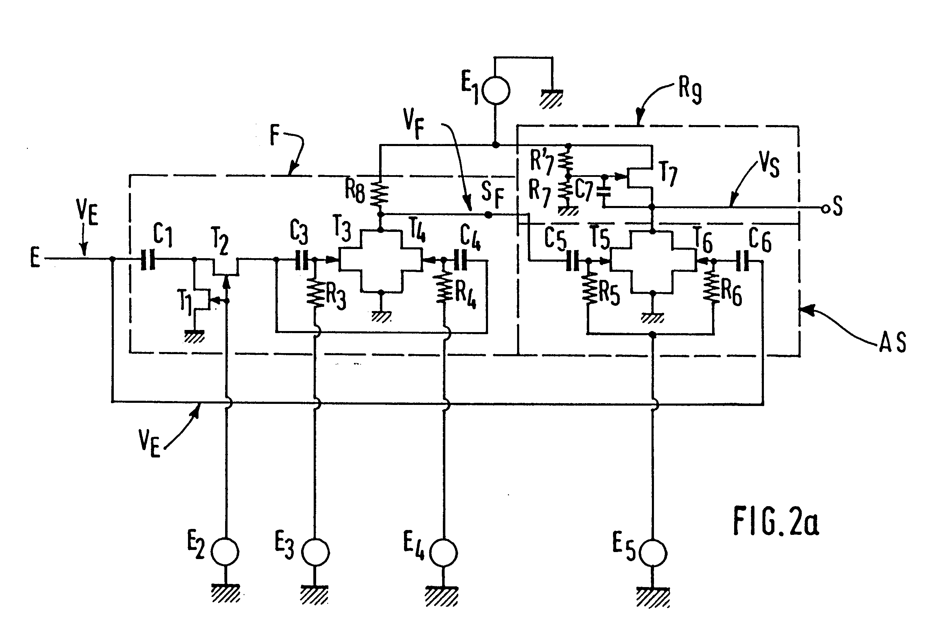

Cet exemple est illustré par la figure 2a.

Le bloc F a pour schéma équivalent pour sa partie passive le circuit PB représenté sur la figure 2b. Il est donc équivalent à une capacité $C_1$ en série avec une résistance $R_2$, une résistance $R_1$ étant montée entre le point commun de $C_1$ et $R_2$, et la masse ; et une capacité $C_2$ étant montée entre la seconde borne de $R_2$ et la masse.

Sur la figure 2a, le circuit PB comprend les transistors à effet de champ $T_1$ et $T_2$ en position des résistances $R_1$ et $R_2$ du schéma de la figure 2b, et utilisés comme résistances ajustables commandées par la source de tension $E_2$.

La capacité $C_1$ du schéma équivalent 2b est formée de la capacité $C_1$ du circuit de la figure 2a. La capacité $C_2$ du schéma équivalent de la figure 2b est formée des capacités intrinsèques des transistors $T_3$ et $T_4$ du circuit de la figure 2a.

Les transistors à effet de champ $T_3$ et $T_4$ sont montés en parallèle, la source reliée à la masse. La grille du transistor $T_3$ est commandée par le signal transmis par $T_2$ et polarisée par une source de tension $E_3$ à travers une résistance $R_3$.

La grille du transistor $T_4$ est commandée par le même signal et polarisée par la source de tension $E_4$ à travers une résistance $R_4$. Les capacités $C_3$ et $C_4$ représentées sur la figure 2a sont des capacités d'isolement.

Le drain commun des transistors $T_3$ et $T_4$ est en outre relié à une source de tension d'alimentation $E_1$ à travers une résistance de charge $R_8$. Le signal de sortie de cet étage F est disponible aux drains communs des transistors $T_3$ et $T_4$.

Tout cet ensemble constitue donc le bloc F du circuit selon l'invention. Cet ensemble peut se décomposer du point de vue du fonctionnement en deux parties.

- la première partie équivalente à $C_1$, $R_1$, $R_2$ du circuit de la figure 2b, est donc formée de $C_1$, $T_1$, $T_2$ de la figure 2a. Elle ne présente pas de gain ;

4

- la seconde partie équivalente à $C_2$ de la figure 2b et à la partie amplificateur du bloc F, est formée de $T_3$, $T_4$ de la figure 2a, et présente un gain voisin de (-$G_{PB}$).

Or selon l'invention, il a été choisi de rendre la fréquence de réjection $f_1$ du filtre PB ajustable. Ce réglage de la fréquence de réjection $f_1$ est obtenu par une variation appropriée de la tension $E_2$ de polarisation de grille des transistors $T_1$ et $T_2$ de la première partie.

La tension $E_2$ sera favorablement appliquée sur les grilles des transistors $T_1$ et $T_2$ à travers une résistance ayant pour ordre de grandeur 10 kQ , qui aura pour effet de protéger les transistors et d'augmenter légèrement la fréquence $f_1$ de réjection.

D'autre part, on peut être amené, lors de l'utilisation du circuit selon l'invention, à faire fonctionner le circuit à des fréquences relativement proches de la fréquence de coupure de l'étage amplificateur du circuit F. Dans ces conditions, cet étage amplificateur, apporte un retard de phase qui rend la fréquence de réjection $f_1$ notablement inférieure à la fréquence centrale du passe-bande PB. Comme le gain des transistors varie aussi notablement avec la fréquence, dans la gamme utilisée pour $f_1$, cela entraîne qu'il est nécessaire de modifier la polarisation de la seconde partie amplificatrice comprenant $T_3$ et $T_4$ lorsque l'on modifie $f_1$.

Selon l'invention, ce réglage de la polarisation se fait aisément du fait que $T_3$ et $T_4$ sont montés en parallèle et polarisés séparément par $E_3$ et $E_4$.

La polarisation de $T_4$ par $E_4$ à travers $R_4$ permet d'ajuster grossièrement le gain (-$G_{PB}$) de l'étage F et la réjection R.

La polarisation de $T_3$ par $E_3$ à travers $R_3$ permet d'ajuster finement la réjection R.

A cet effet, $E_4$ est fixée en fonction de $E_3$. Et le réglage de $E_3$ doit être assez précis. Mais cette précision n'est demandée que dans une faible gamme.

On notera aussi que l'on a choisi de rendre $f_1$ ajustable pour obtenir entre autres deux avantages :

- la possibilité de rattrapage de la valeur de $f_1$ dont les circuits intégrés fournissent toujours des valeurs dispersées, du fait de la dispersion des caractéristiques des éléments d'un circuit à l'autre ;
- la possibilité d'utilisation du même circuit à de nombreuses fréquences différentes.

Reprenant le schéma fonctionnel de la figure 1, les blocs $A_1$, $A_2$ et $S_3$ sont représentés par le bloc AS (amplificateur-sommateur) délimité par des traits pointillés sur la figure 2a.

Le transistor à effet de champ $T_5$ représente l'amplificateur $A_2$ de gain (-$k_2$). Le transistor à effet de champ $T_6$ représente l'amplificateur $A_1$ de gain (-$k_1$).

Les transistors $T_5$ et $T_6$ sont montés en parallèle, la source à la masse, et le signal de sortie $V_S$ est disponible sur leur drain commun, réalisant ainsi la fonction de sommateur $S_3$ recherchée.

Le transistor $T_5$ reçoit sur sa grille le signal de sortie $S_F$ de la partie amplificatrice de l'étage F, c'est-à-dire le signal disponible sur le drain commun des transistors $T_3$ et $T_4$. Le transistor $T_6$ reçoit sur sa grille le signal d'entrée $V_E$. Les grilles des transistors $T_5$ et $T_6$ sont en outre polarisées respectivement à travers les résistances $R_5$ et $R_6$, par la source de tension $E_5$. Le drain commun des transistors $T_5$ et $T_6$ est porté à la tension d'alimentation $E_1$ à travers le circuit de charge $R_9$ formé des résistances $R'_7$ et $R_7$, et du transistor $T_7$ dont la grille est reliée à la source à travers la capacité $C_7$.

L'étage F est isolé de l'étage AS par la capacité $C_5$.

On notera que, ici, le gain du bloc F est -$G_{PB}$, le gain de $A_2$ est -$k_2$ et le gain de $A_1$ est -$k_1$, ce qui revient à ajouter un déphasage de $\pi$ par rapport au schéma fonctionnel de la figure 1.

D'autre part la source de tension $E_5$ appliquée à travers $R_5$ et $R_6$ aux grilles des transistors $T_5$ et $T_6$ respectivement, fixe les gains de ces transistors. Comme il n'est pas indispensable d'obtenir une valeur très précise pour cette tension, la source de tension $E_5$ peut être fusionnée avec l'une des sources de polarisation de grille, par exemple avec $E_3$.

Le tableau II donne à titre d'exemple non limitatif, des valeurs des éléments pour la mise en oeuvre du circuit de la figure 2a avec des transistors à effet de champ du type normalement passant en l'absence de polarisation grillesource présentant une tension de seuil de l'ordre de :

$V_T \simeq$ -2,5 volt,

et une longueur de grille $\ell$ = 0,7 $\mu$m.

Le circuit réalisé à l'aide de transistors à effet de champ de largeur de grille L donnée par le tableau II sur arséniure de gallium et des autres éléments du tableau II, a donné les résultats suivants :

Pour $E_2$ = 0 V, , $f_1 \simeq$ 3,25 GHz
Pour $E_2 \simeq$ -1,8 V , $f_1 \simeq$ 1 GHz.

Au-delà de ces valeurs, c'est-à-dire pour $E_2 < -1,8$ V, d'une façon générale, $f_1$ diminue lorsque $E_2$ diminue, mais devient d'un ajustage plus critique.

En ce qui concerne la réjection R, si la valeur de la source de tension $E_3$ est contrôlée avec une précision de ±25 mV, la réjection R est toujours :

$R \geq 50$ dB à $f_1 \simeq 3,25$ GHz
et $R \geq 48$ dB à $f_1 \simeq 1$ GHz.

On notera qu'à $f_1 \simeq 1$ GHz, la valeur de la réjection R est plus faible car le transistor $T_3$ participe davantage au gain de l'amplificateur du circuit F.

En ce qui concerne le gain obtenu pour le circuit, il est :

$G \simeq 10$ dB.

La polarisation de l'étage amplificateur de F était telle que :
$f_1 \simeq 3,25$ GHz était obtenue pour $E_4 = -0,85$ V et $E_3 = -0,815$V
et $f_1 \simeq 1$ GHz était obtenue pour $E_4 = -1,7$ V et $E_3 = -0,830$ V.

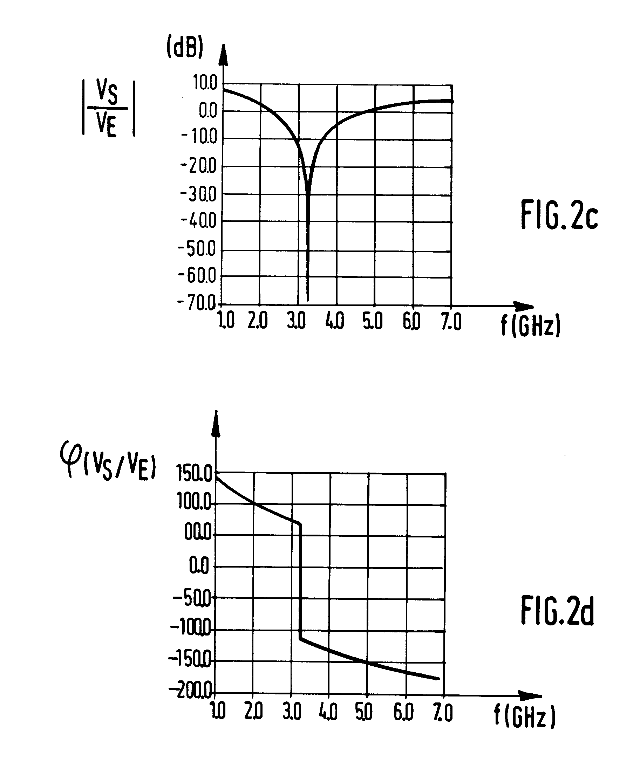

Enfin, à titre d'exemple, la réponse en amplitude du filtre de la figure 2a en fonction de la fréquence f est représentée par la courbe de la figure 2c, obtenue par simulation sur ordinateur ; et la courbe du déphasage $\psi$, également obtenue par simulation sur ordinateur, entre les signaux de sortie $V_S$ et de l'entrée $V_E$ en fonction de la fréquence f est représentée sur la figure 2d.

En reprenant l'équation 16 qui s'applique comme on l'a vu au présent circuit, on a déjà remarqué plus haut que :

1°/ le circuit de filtre selon l'invention est du type coupe-bande lorsque la relation (6) est vérifiée.

La structure selon l'invention permet d'obtenir $Q_1$ positif ou négatif et la relation (10) vérifiée.

2°/ le circuit selon l'invention permet aussi d'obtenir

$$Q_1 = -Q_0,$$

ce qui correspond au cas où le circuit a la fonction de passe-tout. Qui plus est, le circuit selon l'invention permet de passer de la fonction de coupe-bande à la fonction de passe-tout avec les mêmes éléments.

Il suffit en effet de faire varier les polarisations de grille des transistors des différents étages, pour obtenir la variation
soit de $k_1$,
soit de $k_2$,
soit de $G_{PB}$.
On peut alors passer de manière continue de :
$Q_1 = -\infty$ (coupe-bande) à $Q_1 = -Q_0$ (passe-tout).

**TABLEAU I**

$$F_{(s)} = G. \frac{(s/\omega_1)^2 + 1}{(s/\omega_0)^2 + (1/Q_0)(s/\omega_0) + 1} \qquad (1)$$

$$p = s/\omega_1 \qquad (2) \qquad\qquad \omega_1 = \omega_0 = \omega_{PB} \qquad (13)$$

$$s = j\omega \qquad (3) \qquad\qquad Q_0 = Q_{PB} \qquad (14)$$

$$F(j\omega_1) = 0 \qquad (4)$$

$$G(s) = G. \frac{(s/\omega_1)^2 + (1/Q_1)(s/\omega_1) + 1}{(s/\omega_0)^2 + (1/Q_0)(s/\omega_0) + 1} \qquad (5)$$

$$\left| Q_1 \right| > Q_0 \qquad (6)$$
$$\qquad\qquad 1/Q_1 = (1/Q_{PB}) - (k_2/k_1)G_{PB} \qquad (16)$$
$$Q_1 > Q_0. \qquad (7)$$

$$Q_1 < -Q_0 \qquad (8)$$

$$R = \frac{|F(j\omega)| \quad \text{maximale}}{|F(j\omega)| \quad \text{minimale}} \approx \frac{|F(0)|}{|F(j\omega_1)|} \approx \frac{|Q_1|}{Q_0} \qquad (9)$$

$$1/Q_1 = 0 \qquad (10)$$

$$\left| G(j\omega) \right| = G = \text{constante} \qquad (11)$$

$$H(s) = -G_{PB} \frac{s/\omega_{PB}}{(s/\omega_{PB})^2 + (1/Q_{PB})(s/\omega_{PB}) + 1} \qquad (12)$$

$$V_S/V_E = H(s).k_2 + k_1$$

$$= -k_2.G_{PB}. \frac{s/\omega_{PB}}{(s/\omega_{PB})^2 + (1/Q_{PB})(s/\omega_{PB}) + 1} + k_1 \qquad (15)$$

$$= k_1. \frac{(s/\omega_{PB})^2 \left[(1/Q_{PB}) - (k_2/k_1)G_{PB}\right](s/\omega_{PB}) + 1}{(s/\omega_{PB})^2 + (1/Q_{PB})(s\omega_{PB}) + 1}$$

**TABLEAU II**

| Capacités (pF) | | Résistances (kΩ) | | Transistors : L(µm) | | Tension (V) | |
|---|---|---|---|---|---|---|---|
| $C_1$ | 0,2 | $R_3$ | 20 | $T_1$ | 10 | $E_1$ | 6 |
| $C_3$ | 0,5 | $R_4$ | 20 | $T_2$ | 10 | $E_2$ | 0 ↔ -1,8 |
| $C_4$ | 0,5 | $R_5$ | 10 | $T_3$ | 20 | $E_3$ | ≈ -0,8 |
| $C_5$ | 1,0 | $R_6$ | 10 | $T_4$ | 20 | $E_4$ | -0,85 → -1,7 |
| $C_6$ | 1,0 | $R_7$ | 10 | $T_5$ | 20 | $E_5$ | -0,8 |
| $C_7$ | 1,0 | $R'_7$ | 14 | $T_6$ | 20 | | |
| | | $R_8$ | 0,6 | $T_7$ | 20 | | |

**Revendications**

1. Circuit formant un filtre R.C. actif pour application coupe-bande ou passe-tout dans les domaines des hautes et hyperfréquences, à fonction de transfert biquadratique, ayant une entrée E et une sortie S, ce circuit comportant une dite branche comprenant un bloc filtre-amplificateur F pour réaliser une fonction filtre et amplificateur ayant pour entrée E et pour sortie $S_F$, et comportant un bloc $S_3$ sommateur pour

réaliser la sommation $Y_S$ entre le signal de sortie de ladite branche et le signal $V_E$ appliqué à l'entrée E du circuit, caractérisé en ce que ladite branche comprend en outre un bloc amplificateur $A_2$ en série avec le bloc filtre-amplificateur F, placé entre la sortie $S_F$ de ce dernier et la sortie de ladite branche, en ce que le signal d'entrée $V_E$ est appliqué sur le bloc $S_3$ sommateur à travers un bloc amplificateur $A_1$, et en ce que le bloc $S_3$ sommateur est formé par le couplage des sorties des blocs amplificateurs $A_1$ et $A_2$ pour former la sortie S du circuit sur laquelle le signal de sortie $V_S$ est disponible.

2. Circuit selon la revendication 1, caractérisé en ce que le bloc filtre-amplificateur F est un circuit actif contenant un bloc à fonction d'amplificateur et un bloc PB à fonction de passe-bande d'ordre 2.

3. Circuit selon la revendication 2, caractérisé én ce que le circuit du bloc filtre-amplificateur F est équivalent, pour sa partie passive PB, à un filtre formé d'une capacité $C_1$ et une résistance $R_2$ en série entre son entrée E et sa sortie $S_F$, d'une résistance $R_1$ placée entre le point commun à la capacité $C_1$ et à la résistance $R_2$, et d'une capacité $C_2$ placée entre la sortie $S_F$ et la masse.

4. Circuit selon la revendication 3, caractérisé en ce que dans le circuit du bloc filtre-amplificateur F, les résistances $R_1$ et $R_2$ sont constituées par les transistors à effet de champ $T_1$ et $T_2$ respectivement, la source du transistor $T_1$ étant reliée à la masse, son drain étant relié à la source du transistor $T_2$ et à la borne de la capacité $C_1$ opposée à l'entrée E, et les grilles des transistors $T_1$ et $T_2$ étant polarisées par une source de tension continue réglable $E_2$ pour faire varier la valeur des résistances $R_1$ et $R_2$ et la fréquence $f_1$ de réjection du filtre, et en ce que la capacité $C_2$ est constituée par les capacités intrinsèques des transistors à effet de champ $T_3$ et $T_4$ d'un étage amplificateur formé des deux transistors $T_3$ et $T_4$ montés en parallèle, leur source commune reliée à la masse, leur drain commun relié à une source de tension d'alimentation continue $E_1$ à travers une charge $R_8$, les grilles des transistors $T_3$ et $T_4$ étant commandées par le signal disponible sur le drain du transistor $T_2$ à travers les capacités $C_3$ et $C_4$ respectivement, et ces grilles étant de plus polarisées par des sources de tension continue réglables, respectivement $E_3$ à travers une résistance $R_3$ pour le transistor $T_3$ et $E_4$ à travers une résistance $R_4$ pour le transistor $T_4$, la valeur de la tension continue $E_3$ étant choisie pour régler finement la valeur de la réjection R du filtre, et la valeur de la tension continue $E_4$ étant choisie pour régler grossièrement le gain ($-G_{PB}$) de l'étage amplificateur et la réjection R, le signal de sortie $V_F$ du circuit du bloc filtre-amplificateur F étant disponible au point commun des drains des transistors $T_3$ et $T_4$, qui constitue la sortie $S_F$ du bloc filtre-amplificateur F.

5. Circuit selon la revendication 4, caractérisé en ce que le bloc amplificateur $A_2$ est formé d'un transistor à effet de champ $T_5$ dont la source est reliée à la masse, le drain à la sortie S, et dont la grille reçoit à travers une capacité $C_5$ le signal $V_F$ de sortie du bloc filtre-amplificateur F, le drain de ce transistor $T_5$ étant en outre porté à la tension d'alimentation $E_1$ à travers une charge $R_9$ et la grille de ce transistor $T_5$ étant polarisée à travers une résistance $R_5$ par une source de tension continue $E_5$ réglable pour faire varier le gain ($-k_2$) de ce bloc amplificateur, et en ce que le bloc amplificateur $A_1$ est formé d'un transistor à effet de champ $T_6$ monté en parallèle sur le transistor $T_5$ pour réaliser la sommation $S_3$, la grille du transistor $T_6$ recevant à travers une capacité $C_6$ le signal d'entrée $V_E$ du circuit et étant de plus polarisée à travers une résistance $R_6$ par la source de tension $E_5$ pour faire varier le gain ($-k_1$) de ce bloc amplificateur.

6. Circuit selon la revendication 5, caractérisé en ce que la charge $R_9$ des transistors $T_5$ et $T_6$ est une charge active formée d'un transistor à effet de champ $T_7$ dont la source est reliée aux drains communs des transistors $T_5$ et $T_6$, et dont le drain est porté à l'alimentation continue $E_1$, la polarisation de la grille du transistor $T_7$ étant réalisée du fait qu'elle est reliée au point milieu d'un pont diviseur formé des résistances $R_7$ et $R'_7$ placées entre la masse et la tension $E_1$, et cette grille étant en outre reliée à la source de $T_7$ à travers une capacité $C_7$, et en ce que la charge $R_8$ des transistors $T_3$ et $T_4$ est une résistance.

7. Circuit selon l'une des revendications 5 ou 6, caractérisé en ce qu'il présente la fonction d'un coupe-bande par le réglage des valeurs des tensions $E_1$, $E_2$, $E_3$, $E_4$, $E_5$, relativement les unes par rapport aux autres pour obtenir des gains $k_1$, $k_2$, $G_{PB}$ des blocs amplificateurs tels que la réjection R de ce circuit est supérieure à 1.

9

**8.** Circuit selon l'une des revendications 5 ou 6, caractérisé en ce qu'il présente la fonction d'un passe-tout par le réglage des valeurs des tensions $E_1$, $E_2$, $E_3$, $E_4$, $E_5$ relativement les unes par rapport aux autres pour obtenir des gains $k_1$, $k_2$, $G_{PB}$ des blocs amplificateurs tels que le facteur de réjection $Q_1$ est opposé au facteur de qualité $Q_0$.

**9.** Circuit selon l'une des revendications 5 ou 6, caractérisé en ce que, par le réglage des valeurs des tensions $E_3$ et $E_4$ par rapport aux tensions $E_1$, $E_2$, $E_5$, pour obtenir des variations des gains $k_1$, $k_2$, et $G_{PB}$, il est résulte une variation continue du facteur de réjection $Q_1$ entre $-\infty$ et $+\infty$.

**10.** Circuit selon l'une des revendications 4 à 9, caractérisé en ce que qu'il est intégré sur un substrat en arséniure de gallium (GaAs) et réalisé au moyen de transistors à effet de champ du type normalement passant en l'absence de polarisation grille-source.

**Claims**

**1.** Circuit constituting an active RC filter for band-rejection or all-pass applications in the high frequency and microwave regions, with a biquadratic transfer function, comprising an input E and an output S, this circuit including what is commonly referred to as a branch which includes a filter-amplifier block F to effect a filtering and amplifying function and has E as its input and $S_F$ as its output, and includes an adder block $S_3$ to effect the addition $V_S$ of the output signal of the branch and the signal $V_E$ applied to the input E of the circuit, characterized in that the branch furthermore comprises an amplifier block $A_2$ arranged in series with the filter-amplifier block F, inserted between the output $S_F$ thereof and the output of the branch, in that the input signal $V_E$ is applied to the adder block $S_3$ *via* an amplifier block $A_1$, and in that the adder block $S_3$ is formed by coupling the outputs of the amplifier blocks $A_1$ and $A_2$ to form the output S of the circuit at which the output signal $V_S$ is available.

**2.** Circuit as claimed in Claim 1, characterized in that the filter-amplifier block F is an active circuit containing a block functioning as an amplifier and a block PB functioning as a second order band-pass filter.

**3.** Circuit as claimed in Claim 2, characterized in that the filter-amplifier block circuit F is equivalent, as regards its passive portion PB, to a filter constituted by a capacitor $C_1$ and a resistor $R_2$ arranged in series between its input E and its output $S_F$, a resistor $R_1$ positioned between the junction of the capacitor $C_1$ and the resistor $R_2$ and ground, and a capacitor $C_2$ positioned between the output $S_F$ and ground.

**4.** Circuit as claimed in Claim 3, characterized in that in the filter-amplifier block circuit F the resistors $R_1$ and $R_2$ are constituted by the respective field-effect transistors $T_1$ and $T_2$, the source of the transistor $T_1$ being connected to ground, its drain being connected to the source of the transistor $T_2$ and to the terminal of the capacitor $C_1$ opposite the input E, and the gates of the transistors $T_1$ and $T_2$ being biased by a controllable DC voltage source $E_2$ to have the value of the resistors $R_1$ and $R_2$ and the rejection frequency $f_1$ of the filter vary, and in that the capacitor $C_2$ is constituted by intrinsic capacitances of the field-effect transistors $T_3$ and $T_4$ of an amplifier stage formed by two parallel-arranged transistors $T_3$ and $T_4$, their common source being connected to ground, their common drain to a DC supply voltage source $E_1$ *via* a load $R_8$, the gates of the transistors $T_3$ and $T_4$ being controlled by the signal available at the drain of the transistor $T_2$ *via* the respective capacitors $C_3$ and $C_4$, and these gates further being biased by controllable DC voltage sources, $E_3$ *via* a resistor $R_3$ for the transistor $T_3$ and $E_4$ *via* a resistor $R_4$ for the transistor $T_4$ respectively, the value of the DC voltage $E_3$ being chosen for a fine adjustment of the rejection value R of the filter, and the value of the DC voltage $E_4$ being chosen for a coarse adjustment of the gain ($-G_{PB}$) of the amplifier stage and the rejection R, the output signal $V_F$ of the filter-amplifier block circuit F being available at the junction of the drains of the transistors $T_3$ and $T_4$ which constitutes the output $S_F$ of the filter-amplifier block circuit F.

**5.** Circuit as claimed in Claim 4, characterized in that the amplifier block $A_2$ is constituted by a field-effect transistor $T_5$ whose source is connected to ground, the drain to the output S, and whose gate receives the signal $V_F$ from the output of the filter-amplifier block F *via* a capacitor $C_5$, the drain of this transistor $T_5$ further being brought to the supply voltage $E_1$ *via* a load resistor $R_9$ and the gate of this transistor $T_5$ being biased *via* a resistor $R_5$ by a controllable DC voltage source $E_5$ to have the gain ($-k_2$) of this

amplifier block vary, and in that the amplifier block $A_1$ is formed by a field-effect transistor $T_6$ arranged in parallel with the transistor $T_5$ to effect the addition $S_3$, the gate of the transistor $T_6$ receiving the input signal $V_E$ of the circuit *via* a capacitor $C_6$ and further being biased *via* a resistor $R_6$ by the voltage source $E_5$ to have the gain $(-k_1)$ of this amplifier block vary.

6. Circuit as claimed in Claim 5, characterized in that the load $R_9$ of the transistors $T_5$ and $T_6$ is an active load constituted by a field-effect transistor $T_7$ whose source is connected to the common drains of the transistors $T_5$ and $T_6$, and whose drain is brought to the DC supply voltage $E_1$, the bias of the gate of the transistor $T_7$ being realized by connecting it to the centre tap of a divider bridge formed by the resistors $R_7$ and $R'_7$ inserted between ground and the voltage $E_1$, and this gate further being connected to the source of $T_7$ *via* a capacitor $C_7$, and in that the load $R_8$ of the transistors $T_3$ and $T_4$ is a resistor.

7. Circuit as claimed in one of the Claims 5 or 6, characterized in that it has the function of a band-rejection filter by controlling the values of the voltages $E_1$, $E_2$, $E_3$, $E_4$, $E_5$ with respect to each other to obtain the gains k1, k2, $G_{PB}$ of the amplifier blocks so that the rejection R of this circuit is higher than 1.

8. Circuit as claimed in one of the Claims 5 or 6, characterized in that it has the function of an all-pass filter by controlling the values of the voltages $E_1$, $E_2$, $E_3$, $E_4$, $E_5$ with respect to each other to obtain the gains $k_1$, $k_2$, $G_{PB}$ of the amplifier blocks so that the rejection factor $Q_1$ is opposed to the quality factor $Q_0$.

9. Circuit as claimed in one of the Claims 5 or 6, characterized in that, controlling the values of the voltages $E_3$ and $E_4$ with respect to the voltages $E_1$, $E_2$, $E_5$ to obtain variations of the gains $k_1$, $k_2$, and $G_{PB}$, results in a continuous variation of the rejection factor $Q_1$ between $-\infty$ and $+\infty$.

10. Circuit as claimed in one of the Claims 4 to 9, characterized in that it is integrated on a gallium-arsenide (GaAs) substrate and is obtained by using field-effect transistors of a type which is normally conductive in the absence of a gate-source bias.

**Patentansprüche**

1. Schaltungsanordnung, die ein aktives RC-Filter bildet zum Gebrauch als Bandsperre oder als Allpaß im HF- und Mikrowellenbereich, mit biquadratischer Übertragungsfunktion, wobei diese Schaltungsanordnung einen Eingang E und einen Ausgang S aufweist, wobei diese Schaltungsanordnung einen sogenannten Zweig aufweist mit einem Filterverstärkerblock F zum Durchführen einer Filter- und einer Verstärkungsfunktion und wobei E der Eingang desselben ist und $S_F$ der Ausgang und mit einem Addiererblock $S_3$ zum Durchführen der Addierung $V_S$ des Ausgangssignals des Zweiges und des dem Eingang E der Schaltungsanordnung zugeführten Signals $V_E$, dadurch gekennzeichnet, daß der Zweig weiterhin einen Verstärkerblock $A_2$ aufweist, der mit dem Filterverstärkerblock F in Reihe geschaltet ist, wobei dieser Block $A_2$ zwischen dem Ausgang $S_F$ desselben und dem Ausgang des Zweiges vorgesehen ist, daß das Eingangssignal $V_E$ über den Verstärkerblock $A_1$ dem Addierblock $S_3$ zugeführt wird, und daß der Addierblock $S_3$ dadurch gebildet ist, daß die Ausgänge der Verstärkerblöcke $A_1$ und $A_2$ gekoppelt werden zum Bilden des Ausgangs S der Schaltungsanordnung, an dem das Ausgangssignal $V_S$ verfügbar ist.

2. Schaltungsanordnung nach Anspruch 1, dadurch gekennzeichnet, daß der Filter-Verstärkerblock F eine aktive Schaltungsanordnung ist mit einem Block, der als Verstärker wirksam ist und einem Block PB, der als Bandpaß zweiter Ordnung wirksam ist.

3. Schaltungsanordnung nach Anspruch 2, dadurch gekennzeichnet, daß die Schaltungsanordnung des Filter-Verstärkerblocks F, was den passiven Teil FB anbelangt, einem Filter entspricht, das aus einer zwischen dem Eingang E und dem Ausgang $S_F$ vorgesehenen Reihenschaltung aus einem Kondensator $C_1$ und einem Widerstand $R_2$, aus einem zwischen dem gemeinsamen Punkt des Kondensators $C_1$ und des Widerstandes $R_2$ vorgesehenen Widerstand $R_1$, und aus einem zwischen dem Ausgang $S_F$ und Masse vorgesehenen Kondensator $C_2$ gebildet wird.

4. Schaltungsanordnung nach Anspruch 3, dadurch gekennzeichnet, daß in der Schaltungsanordnung des Filter-Verstärkerblocks F die Widerstände $R_1$ und $R_2$ durch die Feldeffekttransistoren $T_1$ bzw. $T_2$

gebildet sind, wobei die Source-Elektrode des Transistors $T_1$ mit Masse verbunden ist, wobei die Drain-Elektrode mit der Source-Elektrode des Transistors $T_2$ und mit der Klemme des gegenüber dem Eingang E liegenden Kondensators $C_1$ verbunden ist und wobei die Gate-Elektroden der Transistoren $T_1$ und $T_2$ aus einer Spannungsquelle mit einer regelbaren Spannung $E_2$ vorgespannt werden, damit der Wert der Widerstände $R_1$ und $R_2$ sowie die Unterdrückungsfrequenz $f_1$ des Filters geändert wird, und daß der Kondensator $C_2$ durch die Eigenkapazitäten der Feldeffekttransistoren $T_3$ und $T_4$ einer durch die zwei parallelgeschalteten Transistoren $T_3$ und $T_4$ gebildeten Verstärkerstufe gebildet wird, wobei die gemeinsame Source-Elektrode an Masse liegt, wobei die gemeinsame Drain-Elektrode über eine Last $R_8$ mit einer Gleichspannungsspeisequelle $E_1$ verbunden ist, wobei die Gate-Elektroden der Transistoren $T_3$ und $T_4$ über die Kondensatoren $C_3$ bzw. $C_4$ durch das Signal gesteuert werden, das an der Drain-Elektrode des Transistors $T_2$ verfügbar ist, und wobei die Gate-Elektroden außerdem durch die regelbare Spannungsquellen vorgespannt werden, und zwar $E_3$ über einen Widerstand $R_4$ für den Transistor $T_3$ und $E_4$ über einen Widerstand $R_4$ für den Transistor $T_4$, wobei der Wert der Gleichspannung $E_3$ derart geregelt ist, daß sie den Wert der Unterdrückung R des Filters fein regeln kann, und wobei der Wert der Gleichspannung $E_4$ derart gewählt worden ist, daß die Verstärkung ($-G_{PB}$) der Verstärker- und Sperrstufe R grob geregelt werden kann, wobei das Ausgangssignal $V_F$ der Schaltungsanordnung des Filter-Verstärkerblocks F an dem gemeinsamen Punkt der Drain-Elektroden der Transistoren $T_3$ und $T_4$ verfügbar ist, wobei dieser Punkt den Ausgang $S_F$ des Filter-Verstärkerblocks F bildet.

5. Schaltungsanordnung nach Anspruch 4, dadurch gekennzeichnet, daß der Verstärkerblock $A_2$ aus einem Feldeffekttransistor $T_5$ gebildet ist, dessen Source-Elektrode mit Masse verbunden ist, wobei die Drain-Elektrode an dem Ausgang S liegt und wobei die Gate-Elektrode über einen Kondensator $C_5$ das Ausgangssignal $V_F$ des Filter-Verstärkerblocks F erhält, wobei die Drain-Elektrode dieses Transistors $T_5$ außerdem über eine Last $R_9$ auf die Speisespannung $E_1$ gebracht wird und wobei die Gate-Elektrode des Transistors $T_5$ über einen Widerstand $R_5$ durch eine regelbare Gleichspannungsquelle $E_5$ vorgespannt wird, um die Verstärkung ($-k_2$) dieses Verstärkerblocks sich ändern zu lassen, und daß der Verstärkerblock $A_1$ aus einem zu dem Transistor $T_5$ parallelgeschalteten Feldeffekttransistor $T_6$ besteht, damit die Summierung $S_3$ verwirklicht wird, wobei die Gate-Elektrode des Transistors $T_6$ über einen Kondensator $C_6$ das Eingangssignal $V_E$ der Schaltungsanordnung erhält und außerdem über emen Widerstand $R_6$ aus der Spannungsquelle $E_5$ vorgespannt wird um die Verstärkung ($-k_1$) des Verstärkerblocks sich ändern zu lassen.

6. Schaltungsanordnung nach Anspruch 5, dadurch gekennzeichnet, daß die Last $R_9$ der Transistoren $T_5$ und $T_6$ eine aktive Last ist, die gebildet wird durch einen Feldeffekttransistor $T_7$, dessen Source-Elektrode mit den gemeinsamen Drain-Elektroden der Transistoren $T_5$ und $T_6$ verbunden ist und dessen Drain-Elektrode auf die Speisegleichspannung $E_1$ gebracht wird, wobei die Vorspannung der Gate-Elektrode des Transistors $T_7$ verwirklicht wird durch die Tatsache, daß diese Gate-Elektrode mit dem Mittenabgriff einer durch die zwischen Masse und der Spannung $E_1$ vorgesehenen Widerstände $R_7$ und $R'_7$ gebildeten Teilerbrücke verbunden ist, und wobei diese Gate-Elektrode außerdem über einen Kondensator $C_7$ mit der Source-Elektrode von $T_7$ verbunden ist, und daß die Last $R_8$ der Transistoren $T_3$ und $T_4$ ein Widerstand ist.

7. Schaltungsanordnung nach einem der Ansprüche 5 oder 6, dadurch gekennzeichnet, daß diese die Funktion einer Bandsperre hat und zwar durch die Regelung der Werte der Spannungen $E_1$, $E_2$, $E_3$, $E_4$ und $E_5$ gegenüber einander zum Erhalten der Verstärkungen $k_1$, $k_2$, $G_{PB}$ der Verstärkerblöcke derart, daß die Unterdrückung R der Schaltungsanordnung größer ist als 1.

8. Schaltungsanordnung nach einem der Ansprüche 5 oder 6, dadurch gekennzeichnet, daß sie die Funktion eines Allpaßes hat und zwar durch die regelung der Werte der Spannungen $E_1$, $E_2$, $E_3$, $E_4$ und $E_5$ gegenüber einander zum Erhalten der Verstärkungen $k_1$, $k_2$, $G_{PB}$ der Verstärkerblöcke derart, daß der Unterdrückungsfaktor $Q_1$ dem Qualitätsfaktor $Q_0$ entgegengesetzt ist.

9. Schaltungsanordnung nach Anspruch 5 oder 6, dadurch gekennzeichnet, daß durch die Regelung der Werte der Spannungen $E_3$ und $E_4$ gegenüber den Spannungen $E_1$, $E_2$, $E_5$, mm Erhalten von Änderungen der Verstärkungen $k_1$, $k_2$ und $G_{PB}$ eine kontinuierliche Variation des Sperrfaktors $Q_1$ zwischen $-\infty$ und $+\infty$ entsteht.

**10.** Schaltungsanordnung nach einem der Ansprüche 4 bis 9, dadurch gekennzeichnet, daß sie auf einem Substrat aus Galliumarsenid (GaAs) integriert ist und mittels Feldeffekttransistoren vom normalen Typ verwirklicht ist, die leitend sind wenn eine Gate-Source-Vorspannung vorhanden ist.

FIG.1

FIG.2b

FIG.2a

EP 0 312 145 B1

(dB)

$\left| \dfrac{V_S}{V_E} \right|$

FIG.2c

$\varphi(V_S/V_E)$

FIG.2d